Europäisches Patentamt
European Patent Office
Office européen des brevets

(19)

(11) Publication number: **0 312 050 A2**

(12) **EUROPEAN PATENT APPLICATION**

(21) Application number: **88117023.7**

(51) Int. Cl.⁴: **G01R 15/02**

(22) Date of filing: **13.10.88**

(30) Priority: **14.10.87 US 108000**

(43) Date of publication of application: **19.04.89 Bulletin 89/16**

(84) Designated Contracting States: **AT BE CH DE ES FR GB GR IT LI LU NL SE**

(71) Applicant: **HYDRO-QUEBEC**
**75, Boulevard René Levesque Ouest**
**Montréal Québec H2Z 1A4(CA)**

(72) Inventor: **Douville, Jean**
**553 Calixa-Lavallée**
**Beloeil Quebec, J3G 4B6(CA)**
Inventor: **Malewski, Ryszard**
**190 Avenue Pitney**
**St-Lambert Quebec, J4B 3B1(CA)**
Inventor: **Lavallée, Louis**
**766 Trudeau**
**Beloeil Quebec, J3G 4S5(CA)**

(74) Representative: **Casalonga, Axel et al**
**BUREAU D.A. CASALONGA - JOSSE**
**Morassistrasse 8**
**D-8000 Munich 5(DE)**

(54) **High voltage measuring circuit coupled to the capacitive grounding tap bushing of an HV device.**

(57) A high voltage measuring circuit for broadband measurement of transient signals occurring in high voltage apparatus. The measuring circuit is housed in a shielded housing having an input sensing circuit for connection to a capacitive grounded tap of the high voltage apparatus. The sensing circuit is connected to an output circuit through an electrical shielded connection. The measuring circuit generates output signals which are replicas of the transient signals appearing on the bushing of the high voltage apparatus. The broadband of the measuring circuit extends over a frequency range of from about 1 Hz to 1 MHz and has a signal level higher than background noise.

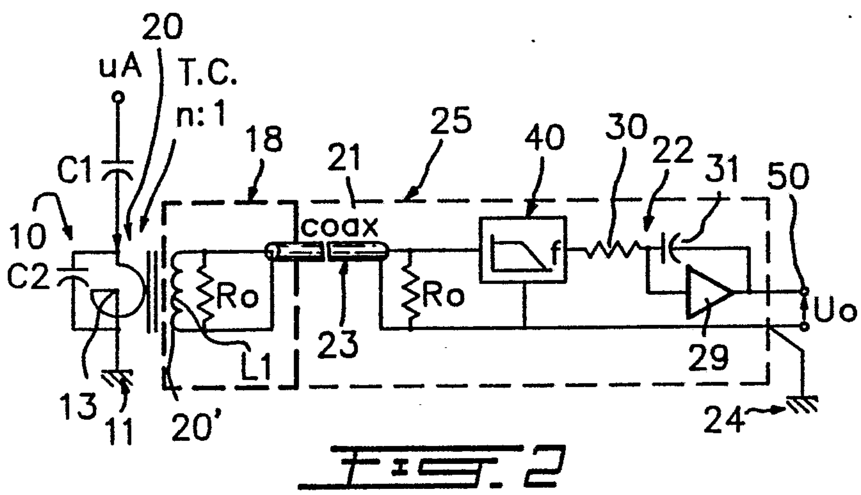


FIG. 2

EP 0 312 050 A2

Xerox Copy Centre

# HIGH VOLTAGE MEASURING CIRCUIT COUPLED TO THE CAPACITIVE GROUNDING TAP BUSHING OF AN HV DEVICE

## BACKGROUND OF INVENTION:

### Field of Invention

The present invention relates to a high voltage measuring circuit which is secured to a capacitive grounding tap bushing of a high voltage power equipment, such as a high voltage transformer, whereby to reproduce transient fault signals that occur on such high voltage apparatus.

### Description of Prior Art

Various high voltage measuring circuits have been developed to measure fault signals on high voltage circuits. However, such circuits do not operate over a wide frequency range, they are complex and costly to construct, and the output signal of such known equipment is often affected by environmental electric or magnetic fields.

## SUMMARY OF INVENTION:

It is a feature of the present invention to provide a high voltage measuring circuit for reproducing transient signals occurring in a high voltage circuit, and which substantially overcomes the above-mentioned disadvantages of the prior art, and wherein the measuring circuit is connected to a capacitive grounding tap bushing of such high voltage power equipment.

According to another feature of the present invention there is provided a high voltage measuring circuit which is isolated from magnetic and electric perturbances and which is capable of reproducing transient signals occurring in high voltage transformers and within a frequency range of between 1 Hz to 1 MHz, and wherein the high voltage measuring circuit is connected to the capacitive grounded bushing of the transformer.

According to the above features, from a broad aspect, the present invention provides a high voltage measuring circuit for broadband measurement of transient signals occurring in high voltage apparatus. The measuring circuit is housed in a shielded housing having an input sensing circuit for connection to a capacitive grounded tap of the high voltage apparatus. The sensing circuit is connected to an output circuit through an electrical shielded connection. The measuring circuit generates output signals which are replicas of the transient signals appearing on the bushing of the high voltage apparatus. The broadband of the measuring circuit extends over a frequency range of from about 1 Hz to 1 MHz and has a signal level higher than background noise.

In a preferred embodiment of the high voltage measuring circuit of the present invention the measuring circuit is connected to the capacitive grounded tap bushing of a high voltage transformer.

## BRIEF DESCRIPTION OF DRAWINGS:

The present invention will now be described with reference to the accompanying drawings in which:

FIGURE 1 is a fragmented view showing the high voltage measuring circuit of the present invention connected to a capacitive grounding tap bushing of a high voltage transformer;

FIGURE 2 is a simplified schematic diagram of the high voltage measuring circuit of the present invention;

FIGURE 3 is a characteristic diagram showing the response of the circuit over a frequency range of from 1 Hz to 1 MHz;

FIGURE 4 is a detailed schematic diagram of the high voltage measuring circuit of the present invention;

FIGURE 5A is a characteristic curve of a high voltage circuit on which there is shown a fault signal; and

FIGURE 5B is a characteristic curve of the fault signal as shown on an expanded scale.

## DESCRIPTION OF PREFERRED EMBODIMENTS:

Referring to the drawings, and more particularly to Figure 1, there is shown a simplified diagram of a capacitive grounded tap bushing 10 having a casing 11 connected to the grounded housing of a high voltage transformer 12. The tap comprises a tap conductor 13 which is usually utilized to test the capacitance of the bushing which is constituted by the insulation 14 layered in the bushing. The insulation is comprised of alternate layers of insulating paper 15 and aluminum foil 16 which are in contact with the bushing casing 11. Usually the current is measured in the outermost foil 16 of the insulation 14, which foil is grounded.

The high voltage measuring circuit 17 of the present invention is housed, at least in part, within a casing 18 which is constructed of steel having a high permeability whereby to shield the components therein against the environmental magnetic field. A coupling 19 connects the primary of the current transformer 20 to the conductor 13. The casing 18 is secured to the bushing 10 by suitable fasteners (not shown).

Referring now to Figure 2, there will be described the construction of the high voltage measuring circuit 17 of the present invention. As shown in Figure 2, the capacitive bushing 10 is schematically illustrated by the capacitors $C_1$ and $C_2$ and conductor 13. This capacitive tap has a certain resonant frequency. The current in the tap is measured by a miniature current transformer 20 and the voltage across the taps of the coil 20′ of the transformer is proportional to the second derivative of the voltage present on the bushing. In order to obtain a replica of this voltage, the signal at the output of the current transformer winding 20′ is twice integrated. The first integration is obtained by a passive LR circuit 21 consisting of the inductance of the secondary coil 20′ of the transformer and its load resistance, herein $R_o$ and $R_o'$ connected in parallel. This load resistance is equal to about 25 ohm. $R_o$ and $R_o'$ are coupling resistances for coaxial cable 23 and each have a value of 50 ohms. The integration circuit 22 constitutes a second integration circuit which purpose is to reproduce a signal that is proportional to the input voltage UA.

After the first integration by the LR circuit 21 the signals become proportional to the first derivative of the measured voltage. The second integration is accomplished by the amplifier 29, the resistor 30 and the capacitor 31.

A low pass filter 40 of the Bessel type and of the 6th order is connected to the input of the integrator amplifier 29, and has a cut-off frequency of 1 MHz. Its function is to eliminate the resonance frequency of the capacitive bushing. This resonance frequency appears at about 3 MHz. The filter also provides an adequate frequency response over the operating range of the measuring circuit.

In order for adequate operation at low frequencies, the current transformer 20 must be efficiently shielded against parasitic magnetic fields and the earth's magnetic field. This is made possible by placing the current transformer 20 in a steel housing 18 having a high permeability. The coaxial cable 23, as well as all of the electronic components of the measuring circuit, are also disposed in the interior of a shield 25 in order not to be affected by any electromagnetic or high frequency electric fields. The ground symbol 11 represents the grounded connection of a transformer while the ground symbol 24 represents an earth ground at the output measuring terminals 50.

The integration circuit, as shown in Figure 2, must be able to integrate the voltage appearing at its input up to 120 db extending over a frequency range of 1 Hz to 1 MHz: It is therefore difficult, while maintaining an acceptable signal to noise ratio, to cover a frequency range of this magnitude. In order to solve this problem, a combined passive and active integrator is utilized as shown in Figure 4. The passive portion of the integrator is constituted by resistor $R_4$ and capacitor $C_2$, and the active part is constituted by the amplifier 29 and its associated resistor $R_5$ and capacitor $C_3$. The transfer equation is given by the following expression:

$$\frac{Uo}{i_s} = \frac{Ro}{\omega R5C3} \times \frac{(1 + \omega R5C3)}{(1 + \omega R4C2)}$$

The crossing point of the active and passive integrators is exact when the relationship of the expression

(1 + ω R5C3)/(1 + ω R4C2)
is unitary. The overlapped frequency is of the range of 2KHz, as shown in Figure 3. Figure 3 is a characteristic representation showing the operation of a measuring circuit over the frequency range of 1 Hz to 1 MHz. The overlapping of the active and passive integrators is illustrated at 51.

Referring now to Figure 5A, there is shown a typical transient fault signal which occurs when closing a high voltage switch. The transient fault signal is identified by reference numeral 42 and appears at the peak voltage of the 60 Hz signal 43. This fault signal is illustrated on a magnified scale in Figure 5B and, as can be seen, it has a very sharp front 44 over a very short rise time. This is a typical type of transient fault signal that the measuring circuit of the present invention can monitor whether appearing on the positive or negative cycle of the signal. Another typical type of fault that is monitored is that which occurs during an explosion in a transformer. This type of monitoring provides valuable information concerning the nature and severity of the fault signals on particular high voltage power equipment, such as high voltage transformers.

It is within the ambit of the present invention to cover any obvious modifications of the examples of the preferred embodiment described herein, provided such modifications fall within the scope of the appended claims.

## Claims

1. A high voltage measuring circuit for broadband measurement of transient signals occurring in high voltage apparatus, said measuring circuit being housed in a shielded housing and having an input sensing circuit for connection to a capacitive grounded tap bushing of said high voltage apparatus, said sensing circuit being connected to an output circuit through an electical shielded connection, said measuring circuit generating output signals which are replicas of the high voltage transients signals appearing on the bushing, said broadband of said measuring circuit extending over a frequency band of from about 1 Hz to 1 MHz and has a signal level higher than background noise, said input sensing circuit having an input current transformer, said current transformer having a primary winding connected to the said bushing capacitive tap and to the bushing flange, said transformer having sufficient number of turns in its secondary winding to maintain a constant transformation ratio up to about 3 HMz, sais secondary of said current transformer having its output integrated by a passive integrator and an active integrator acting respectively in the low and high frequency spectrum of said band and ensuring a constant ratio of the input and output signals of the overall bandwidth of the said measuring circuit.

2. A high voltage measuring circuit as claimed in claim 1 wherein said passive integrator is constituted by an RC circuit connected to said secondary, said activc integrator being comprised of an amplifier and a feedback circuit.

3. A high voltage measuring circuit as claimed in claim 2 wherein said integrators have a transfer equation expressed by the following expression:

$$\frac{Uo}{i_s} = \frac{Ro}{\omega\ R5C3} \times \frac{(1 + \omega\ R5C3)}{(1 + \omega\ R4C2)}$$

the crossing point of said active and passive integrators is exact when the relationship of said expression is unitary and expressed mathematically by:
(1 + ω R5C3)/(1 + ω R4C2)

4. A high voltage measuring circuit as claimed in claim 1 wherein said transformer having a low output resistance of about 25 ohms which acts as an integrator over said broadband frequency range.

5. A high voltage measuring circuit as claimed in claim 1 wherein said output circuit comprises a low pass filter of the 6th order which is connected to said secondary winding of said current transformer, said filter having a cut-off frequency of abou 1 MHz whereby to remove the resonance frequency of said bushing which is situated at about 3 MHz and providing a regularity shaped (aperiodical) step response of the said measuring circuit.

6. A high voltage measuring circuit as claimed in claim 1 wherein said shielded housing is a steel housing having a high permeability to protect said measuring circuit from environmental magnetic fields.

7. A high voltage measuring circuit as claimed in claim 1 wherein the input of said measuring circuit and the output thereof are both separately connected to earth and are electrically isolated from one another.

Neu eingereicht / Newly filed
Nouvellement déposé

FIG. 1

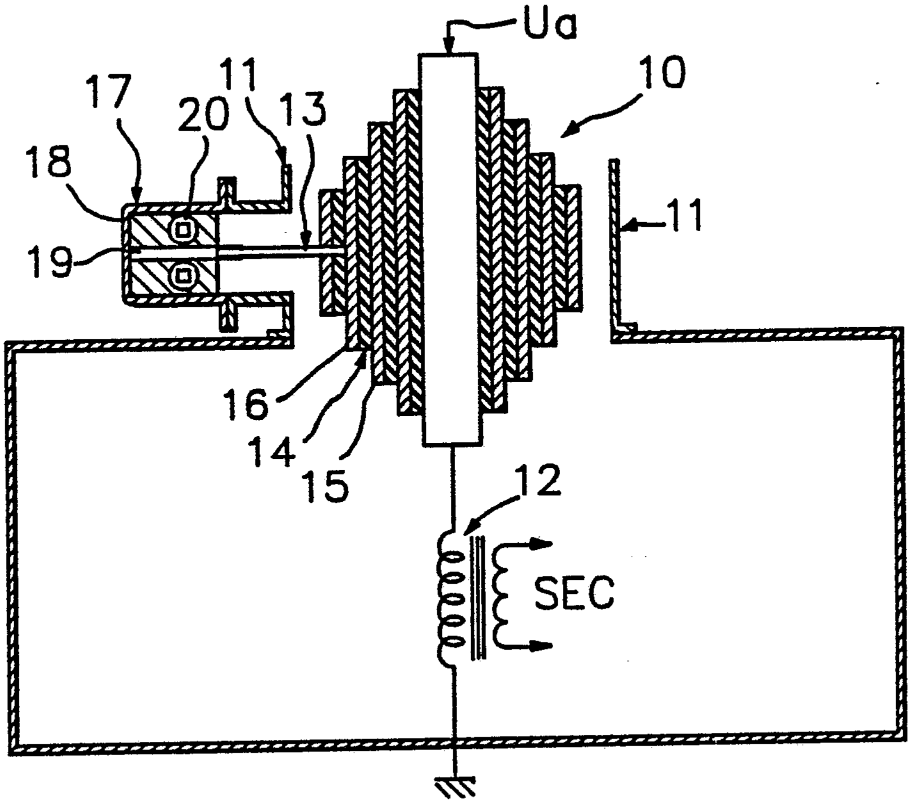


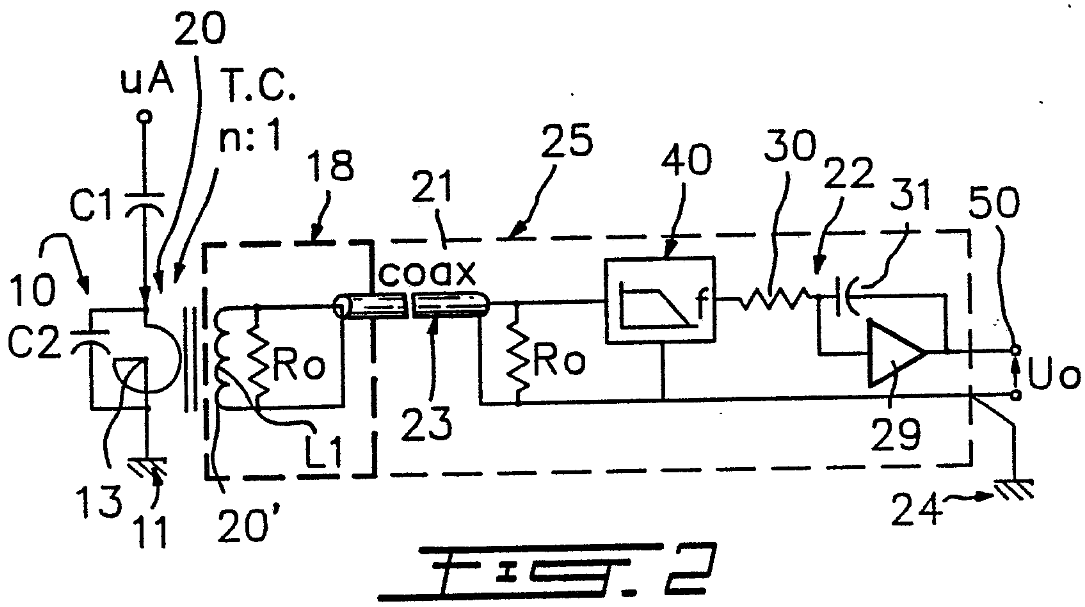


FIG. 2

FIG. 3

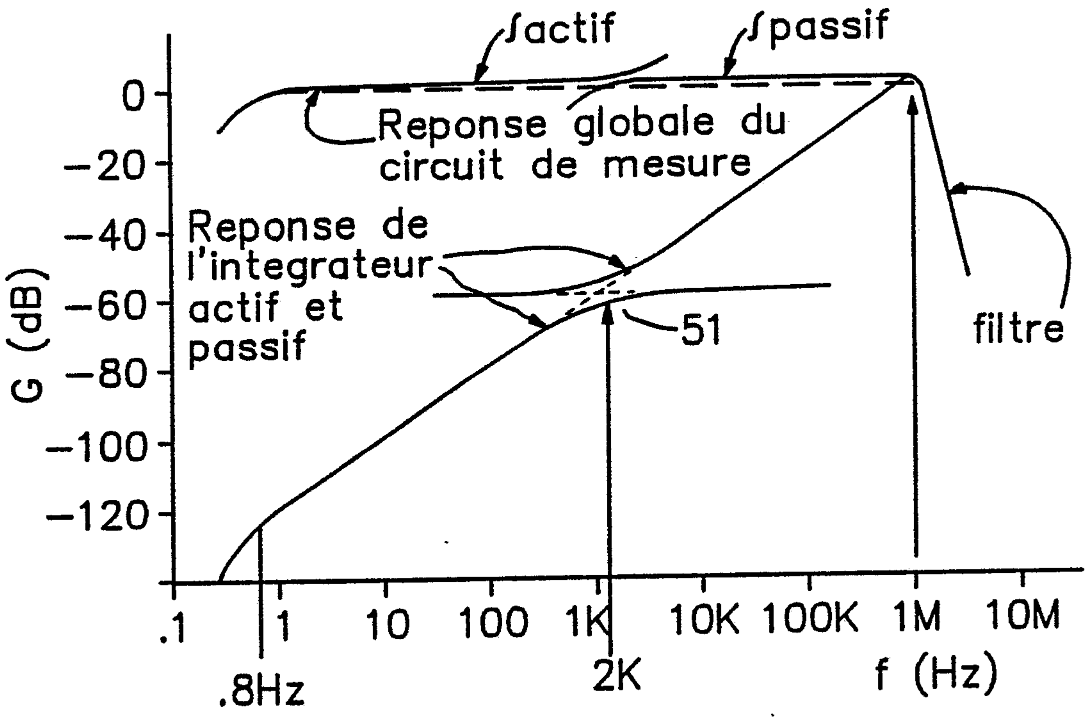
∫actif
∫passif
0
-20
-40
-60
-80
-100
-120
G (dB)
Reponse globale du circuit de mesure
Reponse de l'integrateur actif et passif
51
filtre
.1
1
10
100
1K
10K
100K
1M
10M
.8Hz
2K
f (Hz)

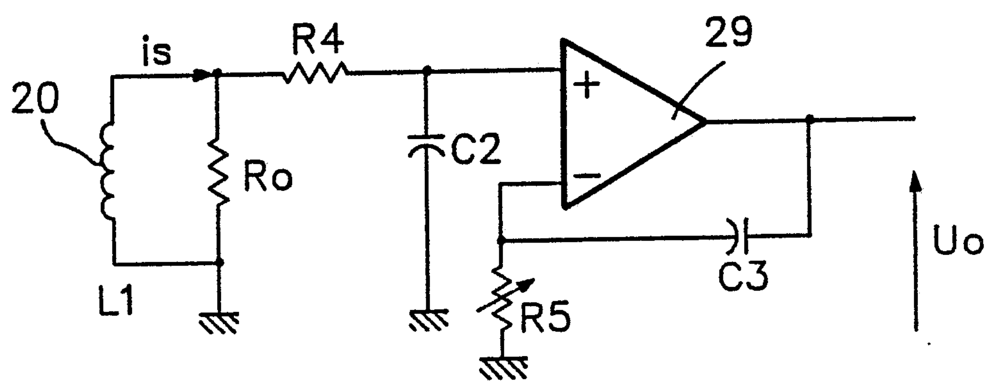
is
R4
29
20
Ro
C2
+
−
L1
R5
C3
Uo

FIG. 4

FIG. 5A

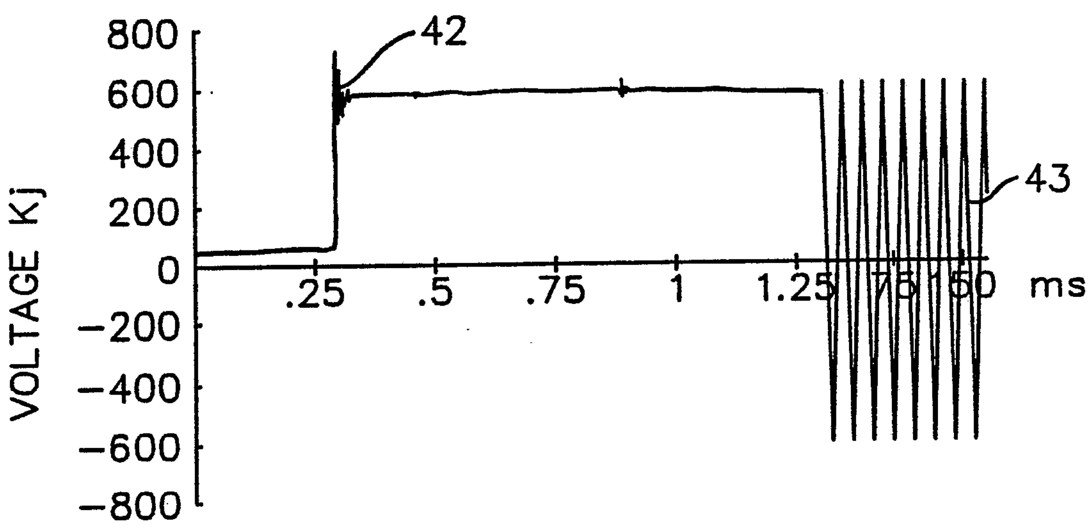
800
600
400
200
0
−200
−400
−600
−800
VOLTAGE Kj
.25
.5
.75
1
1.25
ms
42
43

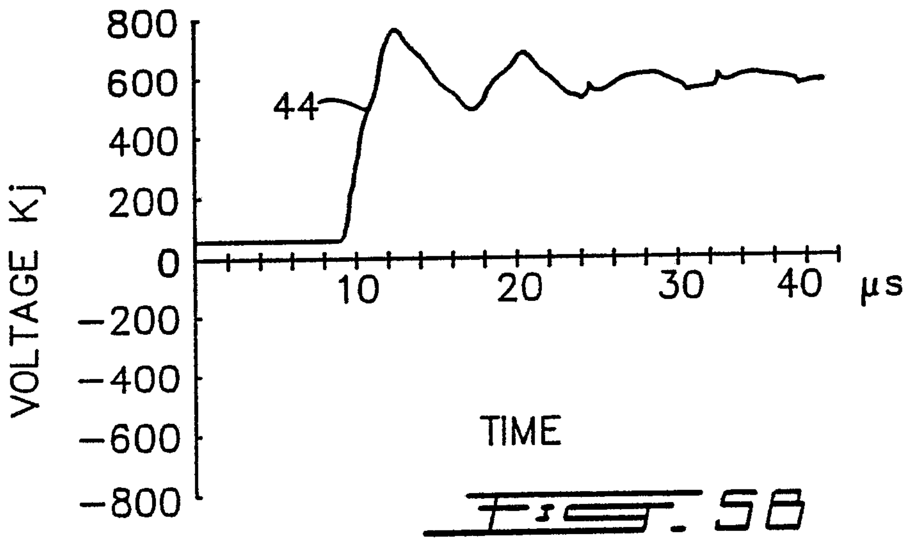
800
600
400
200
0
−200
−400
−600
−800
VOLTAGE Kj
10
20
30
40
µs
44
TIME

FIG. 5B